(19) Europäisches Patentamt / European Patent Office / Office européen des brevets

(11) **EP 1 712 027 B1**

(12) **EUROPEAN PATENT SPECIFICATION**

(45) Date of publication and mention of the grant of the patent:
**27.07.2016 Bulletin 2016/30**

(21) Application number: **05711377.1**

(22) Date of filing: **10.01.2005**

(51) Int Cl.:
**H04L 1/00** $^{(2006.01)}$

(86) International application number:
**PCT/US2005/000948**

(87) International publication number:
**WO 2005/069527 (28.07.2005 Gazette 2005/30)**

(54) **METHOD AND APPARATUS FOR IMPLEMENTING A LOW DENSITY PARITY CHECK CODE IN A WIRELESS SYSTEM**

VERFAHREN UND VORRICHTUNG ZUM IMPLEMENTIEREN EINES PARITÄTSPRÜFCODES NIEDRIGER DICHTE IN EINEM DRAHTLOSEN SYSTEM

PROCÉDÉ ET APPAREIL D'UTILISATION D'UN CODE DE CONTRÔLE DE PARITÉ DE FAIBLE DENSITÉ DANS UN SYSTÈME SANS FIL

(84) Designated Contracting States:
**AT BE BG CH CY CZ DE DK EE ES FI FR GB GR HU IE IS IT LI LT LU MC NL PL PT RO SE SI SK TR**

(30) Priority: **12.01.2004 US 536071 P**
**31.03.2004 US 815133**

(43) Date of publication of application:
**18.10.2006 Bulletin 2006/42**

(73) Proprietor: **Intel Corporation**
**Santa Clara, CA 95052 (US)**

(72) Inventors:
• **XIA, Bo**
**Chandler, AZ 85225 (US)**
• **JACOBSEN, Eric**
**Scottsdale, AZ 85259 (US)**

(74) Representative: **Dunlop, Hugh Christopher et al**
**RGC Jenkins & Co.**
**26 Caxton Street**
**London SW1H 0RJ (GB)**

(56) References cited:
• **YANG M ET AL: "DESIGN OF EFFICIENTLY ENCODABLE MODERATE-LENGTH HIGH-RATE IRREGULAR LDPC CODES" PROCEEDINGS OF THE ANNUAL CONFERENCE ON COMMUNICATION, CONTROL AND COMPUTING, 2 October 2002 (2002-10-02), pages 1415-1424, XP009042018**
• **FUTAKI H ET AL: "Performance of low-density parity-check (LDPC) coded OFDM systems" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. VOL. 1 OF 5, 28 April 2002 (2002-04-28), pages 1696-1700, XP010589776 ISBN: 0-7803-7400-2**
• **SYED M J ET AL: "LDPC-based space-time coded OFDM systems performances over correlated fading channels" COMMUNICATIONS, 2003. APCC 2003. THE 9TH ASIA-PACIFIC CONFERENCE ON 21-24 SEPT. 2003, PISCATAWAY, NJ, USA,IEEE, vol. 2, 21 September 2003 (2003-09-21), pages 590-594, XP010688253 ISBN: 0-7803-8114-9**

**Description**

<u>TECHNICAL FIELD</u>

The invention relates generally to wireless communications and, more particularly, to error correction coding schemes for use in wireless systems.

<u>BACKGROUND</u>

Wireless channels are often plagued by noise and/or interference effects that can compromise the quality of the communication flowing there through. One strategy for addressing these concerns involves the use of a forward error correction code to encode data before it is transmitted. The forward error correction code adds redundant information to the original data that allows errors in transmission to be corrected after signal reception. Structures and techniques are needed for reliably and efficiently implementing forward error correction in wireless systems.

YANG M et al.: "Design of Efficiently Encodable Moderate-Length High-Rate Irregular LDPC Codes" Proceedings of the Annual Conference on Communication, Control and Computing, 2 October 2002, pages 1415-1424 discloses improving performance of systems using LDPC coding corresponding to the features of the preamble of the independent claims.

FUTAKI H et al.: "Performance of low-density parity-check (LDPC) coded OFDM systems" ICC 2002 proceedings NY, April 28 - May 2, 2002: IEEE, US, vol. VOL. 1 OF 5, 28 April 2002, pages 1696-1700 and SYED M J et al.: "LDPC-based space-time coded OFDM systems performances over correlated fading channels" APCC 2003, IEEE, vol. 2, 21 September 2003, pages 590-594 also relate to improving performance of systems using LDPC coding.

<u>STATEMENT OF INVENTION</u>

The present invention is defined by the features of the independent claims. Preferred advantageous embodiments thereof are defined by the features of the dependent claims.

<u>BRIEF DESCRIPTION OF THE DRAWINGS</u>

FIG. 1 is a block diagram illustrating an example wireless network arrangement in accordance with an embodiment of the present invention;

FIG. 2 is a block diagram illustrating an example orthogonal frequency division multiplexing (OFDM) transmitter chain that may be used within a wireless device in accordance with an embodiment of the present invention;

FIG. 3 is a block diagram illustrating an example LDPC encoder in accordance with an embodiment of the present invention;

FIG. 4 is a diagram illustrating a Tanner graph that describes an example LDPC code; and

FIG. 5 is a flowchart illustrating an example method for use in processing data within a wireless device in accordance with an embodiment of the present invention.

<u>DETAILED DESCRIPTION</u>

In the following detailed description, reference is made to the accompanying drawings that show, by way of illustration, specific embodiments in which the invention may be practiced. These embodiments are described in sufficient detail to enable those skilled in the art to practice the invention. It is to be understood that the various embodiments of the invention, although different, are not necessarily mutually exclusive. For example, a particular feature, structure, or characteristic described herein in connection with one embodiment may be implemented within other embodiments without departing from the scope of the claims. In addition, it is to be understood that the location or arrangement of individual elements within each disclosed embodiment may be modified without departing from the scope of the claims. The following detailed description is, therefore, not to be taken in a limiting sense, and the scope of the present invention is defined only by the appended claims, appropriately interpreted, along with the full range of equivalents to which the claims are entitled. In the drawings, like numerals refer to the same or similar functionality throughout the several views.

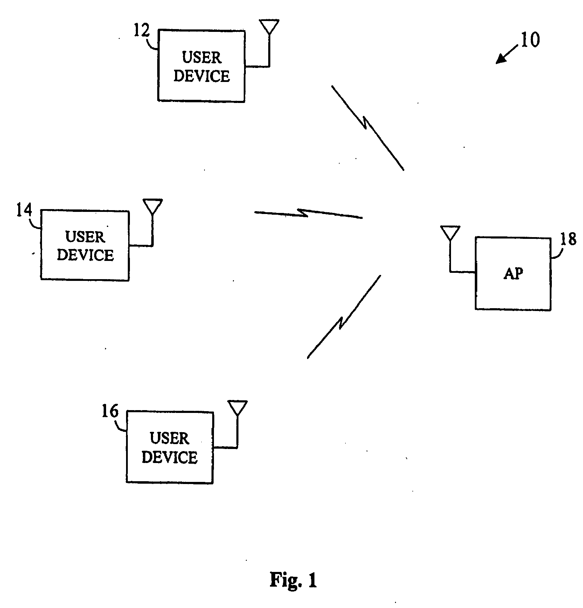

FIG. 1 is a block diagram illustrating an example wireless network arrangement 10 in accordance with an embodiment of the present invention. As illustrated, one or more wireless user devices 12, 14, 16 are communicating with a wireless access point (AP) 18 via corresponding wireless links. The AP 18 provides access to a network for the user devices 12, 14, 16 (e.g., a private network, a public network, the Internet, a public switched telephone network, a local area network (LAN), a municipal area network (MAN), a wide area network (WAN), and/or others). The wireless user devices 12,14,16 may include any form of device that may be used to wirelessly access a network including, for example, a laptop, desktop, palmtop, or tablet computer having wireless networking capability, a personal digital assistant (PDA) having wireless networking capability, a cellular telephone or other handheld wireless communicator, a pager, and/or others. The wireless links between the wireless devices 12,14, 16 and the access point 18 may experience noise and/or various interference effects that can compromise communication quality. To overcome such problems, forward error correction may be used. That is, a forward error correction (FEC) coder may be provided within a transmitting device to encode data before it is wirelessly transmitted. When the signal is received, a FEC decoder may be used to decode the signal. The FEC decoder is capable of detecting and correcting one or more errors in the received data. In this manner, errors caused by noise and/or interference effects in the channel may be overcome. In one aspect of the present invention, a low density parity check (LDPC) code is used as a FEC code within a wireless device.

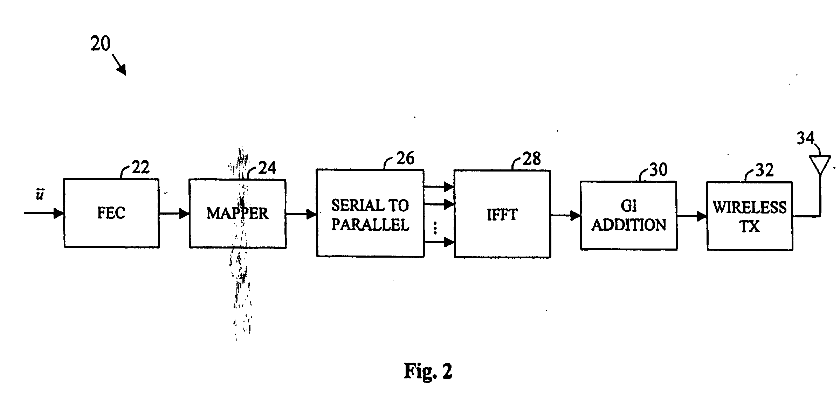

In at least one embodiment, features of the present invention are implemented within an orthogonal frequency division multiplexing (OFDM) based wireless system. Fig. 2 is a block diagram illustrating an example OFDM transmitter chain 20 that may be used within a wireless device (e.g., a wireless user device, a wireless access point, etc.) in accordance with an embodiment of the present invention. As illustrated, the transmitter chain 20 may include one or more of: a FEC coder 22, a mapper 24, a serial to parallel converter 26, an inverse fast Fourier transform (IFFT) unit 28, a guard interval (GI) addition unit 30, a wireless transmitter 32, and one or more transmit antennas 34. The FEC coder 22 receives user data at an input thereof and encodes the data using a forward error correction code. As will be described in greater detail, in at least one embodiment, the FEC coder 22 may utilize a special form of low density parity check (LDPC) code to perform the coding. The mapper 24 receives code words from the FEC coder 22 and maps the code words based upon a predetermined modulation constellation. Any form of modulation scheme may be used, including, for example, binary phase shift keying (BPSK), quadrature phase shift keying (QPSK), 16 symbol quadrature amplitude modulation (16-QAM), 64 symbol quadrature amplitude modulation (64-QAM), and/or others. The serial to parallel converter 26 transforms a serial stream of modulation symbols output by the mapper 24 into a parallel format for delivery to the IFFT 28. The IFFT 28 performs an inverse fast Fourier transform on the modulation symbols input thereto to convert the symbols from a frequency domain representation to a time domain representation. Although illustrated as an inverse fast Fourier transform in Fig. 2, it should be understood that any form of inverse discrete Fourier transform may be used in the transmitter chain 20.

The GI addition unit 30 adds a guard interval to the time domain signal representation output by the IFFT 28. Guard intervals are placed in transmitted signals to, among other things, increase the immunity of the signals to, for example, multipath effects in the channel. The wireless transmitter 32 is operative for performing functions such as, for example, up-converting the signal, power amplifying the signal, etc. before transmission. One or more transmit antennas 34 may be provided to facilitate signal transmission into the wireless channel. Any form of antenna(s) may be used including, for example, a dipole, a patch, a helix, an antenna array, and/or others. In at least one embodiment, antenna diversity techniques are implemented. In some other embodiments, multiple input, multiple output (MIMO) techniques are used. Other forms of wireless transducer may alternatively be used instead of antennas (e.g., a infrared (IR) diode in an IR-based wireless system, etc.).

It should be appreciated that the transmitter chain 20 of Fig. 2 is merely illustrative of one possible transmitter architecture that may utilize features of the invention. Many other architectures may alternatively be used. In at least one embodiment, a transmitter chain is used that is configured in accordance with an IEEE 802.11 wireless networking standard (ANSI/IEEE Std 802.11-1999 Edition and its progeny). Other wireless standards may alternatively or additionally be used.

As described above, in at least one embodiment of the invention, the FEC coder 22 may utilize a low density parity check (LDPC) code to perform the forward error correction coding. In a general analysis, an (n,k) LDPC code has k information bits and n coded bits with code rate r = k/n. A parity check matrix H of dimension (n-k)xn may be developed that fully describes the LDPC code. The parity check matrix H defines a set of equations:

$$\bar{v} \cdot H^t = 0 \qquad \text{(Equation 1)}$$

for all code words *v* of the code, where H' is the transpose of parity check matrix H. An example parity check matrix H and the corresponding expanded parity check equations are shown below for an LDPC code (9,3):

$$H \begin{bmatrix} 1 & & 1 & & 1 & \\ & 1 & & 1 & & 1 \\ & & 1 & & 1 & & 1 \\ 1 & & & 1 & & & 1 \\ & 1 & & & 1 & 1 & \\ & & 1 & 1 & & & 1 \end{bmatrix} \Longleftrightarrow \begin{cases} v_1 - v_4 - v_7 & 0 \\ v_2 - v_3 - v_8 & 0 \\ v_3 - v_5 - v_9 & 0 \\ v_1 - v_3 - v_9 & 0 \\ v_2 - v_5 - v_7 & 0 \\ v_3 - v_4 - v_8 & 0 \end{cases}.$$

where $v_k$ represents the bits of the codeword v. LDPC codes may be encoded via a generator matrix G. For a given information vector $\overline{u}$ to be encoded, the corresponding code word $\overline{v}$ may be generated as follows:

$$\overline{v} = \overline{u} \cdot G \qquad \text{(Equation 2)}$$

From equations 1 and 2, it follows that:

$$\overline{u} \cdot G \cdot H^t = 0 \qquad \text{(Equation 3)}$$

Since $\overline{u}$ is an arbitrary vector, the following relationship applies:

$$G \cdot H^t = 0 \qquad \text{(Equation 4)}$$

For a given parity check matrix H, there will typically be $2^k$ different G matrices that satisfy Equation 4, provided the rank of the H matrix is n-k. One of these generator matrices has the format:

$$G = [I_{k \times k} \mid P_{k \times (n-k)}] \qquad \text{(Equation 5)}$$

where $I_{k \times k}$ is a kxk identity matrix and $P_{k \times (n-k)}$ is a kxn-k matrix. A coder implementing the generator matrix of Equation 5 is known as a systematic encoder since the first k bits of the code word are identical to the k information bits.

The parity check matrix H for an LDPC code may be represented as having two sub-matrices, as follows:

$$H = [H_1 \mid H_2] \qquad \text{(Equation 6)}$$

where sub-matrix $H_1$ has dimension (n-k)*k and sub-matrix $H_2$ has dimension (n-k)*(n-k). According to Equation 4, and assuming that $H_2$ is non-singular, it follows that:

$$I \cdot H_1^t + P \cdot H_2^t = 0 \Rightarrow P = H_1^t H_2^{-t} \qquad \text{(Equation 7)}$$

and the codeword $\overline{v}$ is in the format:

$$\overline{v} = \overline{u} \cdot G = [\overline{u} \mid \overline{u}P] = [\overline{u} \mid \overline{u}H_1^t H_2^{-t}] \qquad \text{(Equation 8)}$$

For some LDPC codes, high encoding complexity may arise if a high density $H_2^{-t}$ matrix is used in Equation 8 above. However, in at least one embodiment of the present invention, the sub-matrix $H_2$ is implemented as $f(D) = 1 + D$, which allows $H_2^{-t}$ to be realized using a well known differential encoder. The encoding process in such an embodiment may be expressed as:

$$\bar{v} = [\bar{u} \mid \bar{u}H_1{}'H_2{}^{-t}] = \left[\bar{u} \mid \bar{u}H_1{}' \frac{1}{1+D}\right] \qquad \text{(Equation 9)}.$$

where D is a unit delay.

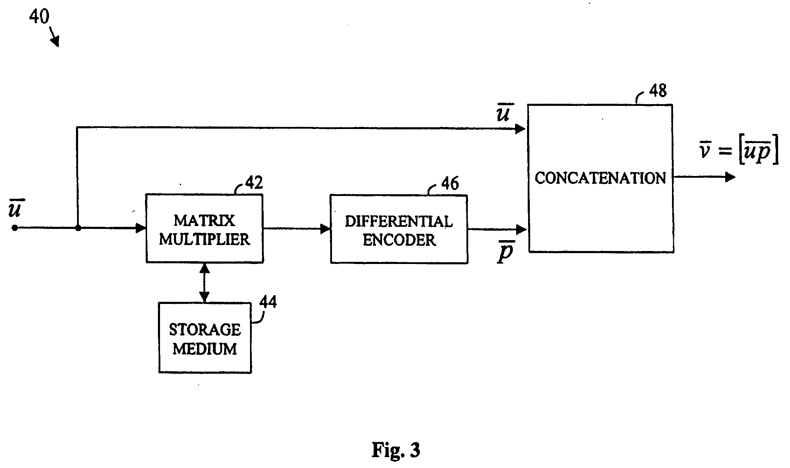

Fig. 3 is a block diagram illustrating an example LDPC encoder 40 in accordance with an embodiment of the present invention. The LDPC encoder 40 may be implemented as part of, for example, the FEC unit 22 of Fig. 2 or FEC functionality within other wireless devices. As illustrated, the LDPC encoder 40 includes: a matrix multiplier 42, a storage medium 44, a differential encoder 46, and a concatenation unit 48. The storage medium 44 is operative for storing a representation of the sub-matrix $H_1$ (or the entire parity check matrix $H$) for use in LDPC encoding. The matrix representation stored on the storage medium 44 may be in conventional matrix form, in list file form (as in Appendix A), in transpose form, or in any other form that is descriptive of the content of the matrix. Although not shown, the information stored within the storage medium 44 may also be used to perform LDPC decoding within the corresponding wireless apparatus (i.e., during receive operations). Any type of storage medium may be used including, for example, a semiconductor memory, a read only memory (ROM), a random access memory (RAM), an erasable programmable read only memory (EPROM), an electrically erasable programmable read only memory (EEPROM), a flash memory, a magnetic or optical card, a magnetic disk, an optical disk, a CD-ROM, a magneto-optical disk, and/or other forms of machine readable storage. The storage medium 44 may be a dedicated storage unit (e.g., to store only the parity check matrix $H$, the sub-matrix $H_1{}'$, etc.) or it may also be used to store other information.

The matrix multiplier 42 receives an information vector $\bar{u}$ at an input thereof. The matrix multiplier 42 then performs a matrix multiplication of the vector $\bar{u}$ and the sub-matrix $H_1{}'$. The result of the matrix multiplication is then delivered to the differential encoder 46 which performs a differential encoding operation thereon (i.e., $\frac{1}{1+D}$). The matrix multiplier 42 and the differential encoder 46 may operate independently of one another or their operation may be pipelined (e.g., once a bit is output from the matrix multiplier 42 it is immediately used by the differential encoder 46). The output of the differential encoder 46 is vector $\bar{p}$. The concatenation unit 48 concatenates the original information vector $\bar{u}$ with the vector $\bar{p}$ to generate the codeword $\bar{v}$. The codeword $\bar{v}$ may then be delivered to a next processing stage within a wireless transmitter chain (e.g., mapper 24 in the transmitter chain 20 of Fig. 2).

In at least one embodiment of the present invention, a (2000, 1600) LDPC code is implemented within the transmitter chain of a wireless apparatus. A list file describing a parity check matrix H that is used in one such implementation is set out in Appendix A herein. The list file of Appendix A describes the data within the corresponding parity check matrix. The parity check matrix H of Appendix A (or a portion thereof) may be stored within, for example, the storage medium 44 of Fig. 3. In at least one embodiment, only the portion of the parity check matrix H of Appendix A that corresponds to sub-matrix $H_1$ (or the transpose thereof) is stored within the storage medium 44 (i.e., the columns having a weight of 4 in the matrix description of Appendix A). The sub-matrix $H_1$ of the parity check matrix $H$ of Appendix A is relatively low-density with a uniform column weight of four. The LDPC code corresponding to the matrix $H$ of Appendix A has been designed to provide good performance with variable-length data blocks, while still achieving a manageable implementation complexity. The codeword length has been selected to provide a good tradeoff between performance and complexity for use in wireless (and some wireline) applications. It should be appreciated that small variations may be made to the parity check matrix $H$ of Appendix A with little or no degradation in performance. As used herein, a matrix is "substantially as described in the list file of Appendix A" if the matrix is the same as the matrix described in Appendix A or the matrix varies from the matrix described in Appendix A in a manner that produces little or no degradation in performance.

It should be understood that the parity check matrix H described in Appendix A is merely one example of a parity check matrix that may be used in accordance with embodiments of the present invention. In other embodiments, other parity check matrices may be used.

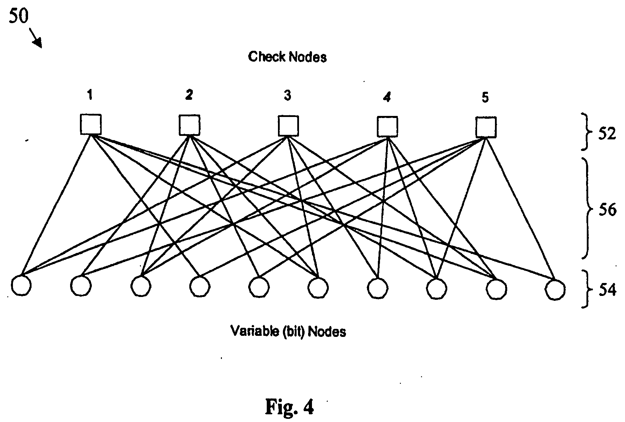

As described above, the parity check matrix H of Appendix A is described using a list file. This method of matrix description will be discussed below. A parity check matrix H will typically include ones and zeros in locations throughout the matrix. The list file of Appendix A describes the locations of these one and zeros for the subject matrix. A full definition of an LDPC code can be accomplished through identification of the locations of the "edges" between the "variable nodes" (codeword bits) and "check nodes" (parity relationships). Fig. 4 is a diagram illustrating a Tanner graph 50 that describes an example LDPC code. The Tanner graph 50 illustrates the arrangement of the check nodes 52, the variable nodes 54, and the "edges" 56 connecting them for the corresponding code. The codeword is made up of the bits represented by the variable nodes 54. For the code of Fig. 4, each codeword has ten bits. Each check node 52 represents a parity relationship between the codeword bits represented by the variable nodes 54 connected to it by the edges 56. The number of edges 56 connected to a check node 52 is called the "degree" of the check node 52. Likewise, the number of edges 56 connected to a variable node 54 is called the "degree" of the variable node 54. For the illustrated code, all check nodes 52 are of degree eighteen, all variable nodes 54 related to the systematic information bits are of degree four, and all variable nodes 54 corresponding to parity bits are of degree two, except for the last, which is of degree one.

Since the organization of the edges in LDPC codes appears random, the edge locations must be explicitly defined by means of a list. A straightforward means of describing a code by means of such a list follows. The matrix H = [H$_1$ H$_2$] comprises a regular matrix H$_1$ with constant column weight 4 and a weight-2 lower-triangular-inverse matrix H$_2$ for efficient encoding purposes. An LDPC code list file may contain three parts to fully describe a parity check matrix H (i.e., all of the ones of the matrix):

(a) matrix size (column, row); (b) column weights (number of ones) of each column; and (c) locations of ones in each column. It should be noted that the convention for the indices is zero-based, with the index of the first element of each column being zero. An example H matrix for a (9,3) LDPC code follows:

$$H = \begin{bmatrix} 1 & 0 & 0 & 1 & 0 & 0 & 1 & 0 & 0 \\ 0 & 1 & 0 & 0 & 1 & 0 & 0 & 1 & 0 \\ 0 & 0 & 1 & 0 & 0 & 1 & 0 & 0 & 1 \\ 1 & 0 & 0 & 0 & 0 & 1 & 0 & 1 & 0 \\ 0 & 1 & 0 & 1 & 0 & 0 & 0 & 0 & 1 \\ 0 & 0 & 1 & 0 & 1 & 0 & 1 & 0 & 0 \end{bmatrix}$$

and the corresponding list file is:

```
9 6
2 2 2 2 2 2 2 2 2
0 3
1 4
2 5
0 4
1 5
2 3
0 5
1 3
2 4
```

The list file set out in Appendix A for the (2000, 1600) LDPC code follows the same basic approach.

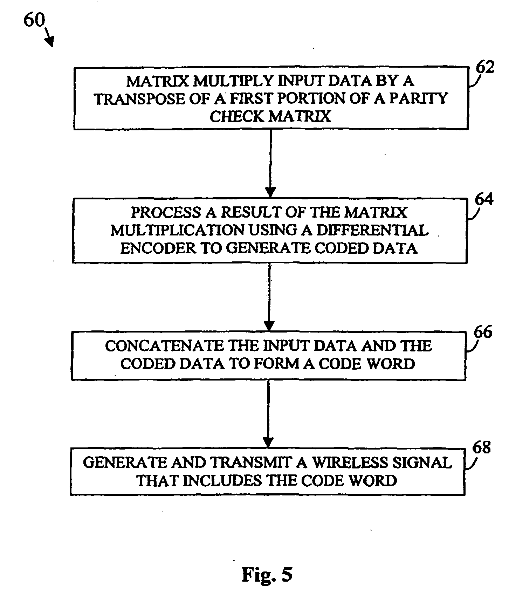

Fig. 5 is a flowchart illustrating an example method 60 for use in processing data within a wireless device in accordance with an embodiment of the present invention. Input data is first matrix multiplied by a transpose of a first portion (i.e., $H_1^t$) of a parity check matrix H (block 62). The parity check matrix H (or some portion thereof) may be stored within a storage medium of the wireless device. In at least one embodiment, the parity check matrix H described in Appendix A is used. A result of the matrix multiplication may then be processed by a differential encoder to generate coded data (block 64). The original input data and the coded data are then concatenated to form a code word (block 66). A wireless signal is subsequently generated and transmitted that includes the code word (block 68). Other code words may also be part of the transmission. In at least one embodiment, the wireless signal is an orthogonal frequency division multiplexing (OFDM) signal. In at least one implementation, the method 60 of Fig. 5 (or a variant thereof) is

**EP 1 712 027 B1**

embodied as a plurality of instructions stored on a machine readable storage medium that may be executed by a digital processing device.

The inventive techniques and structures may be used in any of a wide variety of different wireless devices, components, and systems. For example, in various embodiments, features of the invention may be implemented within laptop, desktop, palmtop, and/or tablet computers having wireless networking functionality, personal digital assistants (PDAs) having wireless networking functionality, cellular telephones and other handheld wireless communicators, pagers, satellite communication devices, devices for use in point to point wireless links, devices for use in local multipoint distribution systems (LMDS) and/or multichannel multipoint distribution services (MMDS), wireless network interface cards (NICs) and other network interface structures, integrated circuits, and/or other devices.

In the foregoing detailed description, various features of the invention are grouped together in one or more individual embodiments for the purpose of streamlining the disclosure. This method of disclosure is not to be interpreted as reflecting an intention that the claimed invention requires more features than are expressly recited in each claim. Rather, as the following claims reflect, inventive aspects may lie in less than all features of each disclosed embodiment.

Although the present invention has been described in conjunction with certain embodiments, it is to be understood that modifications and variations may be resorted to without departing from the scope of the claims as those skilled in the art readily understand. Such modifications and variations are considered to be within the purview and scope of the invention and the appended claims.

APPENDIX A

The list file for an example (2000, 1600) LDPC code is set out below:

7

EP 1 712 027 B1

2000 400

4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4 4
4 4 4 4 4 4 4 4 4 4 4 4 4 4 4 4 4 4 4 4 4 4 4 4 4 4 4 4 4 4 4 4 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2 2
2 2 2 2 2 2 2 2 2 2 2 2 2 2 2 2 2 2 2 2 2 2 2 1

| 143 225 316 323 | 180 186 241 251 | 57 211 274 360 |
| 92 140 191 358 | 239 254 331 342 | 12 291 311 348 |
| 69 315 329 343 | 107 149 250 295 | 34 220 258 282 |
| 6 121 205 284 | 73 221 295 362 | 52 58 109 379 |
| 58 66 254 337 | 75 97 242 279 | 116 248 337 369 |
| 1 47 178 395 | 32 197 244 313 | 87 146 183 278 |
| 129 151 212 228 | 245 248 276 296 | 42 96 318 361 |
| 66 146 243 265 | 59 230 322 347 | 32 176 312 361 |
| 22 140 157 180 | 17 246 291 364 | 69 258 310 389 |
| 120 208 313 321 | 125 157 227 390 | 1 84 182 300 |
| 290 350 370 382 | 122 205 279 348 | 45 124 161 396 |
| 5694 184215 | 61 298 340 380 | 15 76 99 101 |
| 84 119 337 344 | 12 31 256 328 | 62 248 354 375 |
| 2 156 244 398 | 119 163 178 217 | 78 258 262 311 |
| 9 106 200 336 | 61 129 185 200 | 181 265 364 368 |
| 2237 150 270 | 34 38 104 295 | 60 168 227 254 |
| 3 110 326 367 | 119 289 349 377 | 162 231 270 377 |

(continued)

| | | |
|---|---|---|
| 235 276 290 335 | 50 314 322 367 | 14 102 139 158 |
| 82 187 193 297 | 28 48 248 382 | 28 79 155 318 |
| 43 183 297 379 | 32 41 128 201 | 28 40 63 236 |
| 194 239 243 293 | 91 115 220 368 | 163 181 258 279 |
| 90 144 228 350 | 45 151 196 265 | 158 176 273 334 |
| 170 206 321 395 | 152 190 198 317 | 80 236 256 380 |
| 72 138 254 300 | 157 212 242 275 | 74 156 214 358 |
| 25 196 201 279 | 2 40 249 283 | 176 229 251 283 |
| 56 59 362 379 | 195 280 299 345 | 19 104 114 162 |
| 28 121 170 277 | 142 151 220 395 | 141 284 291 358 |
| 61 273 351 386 | 70 121 252 382 | 77 123 157 361 |
| 71 76232328 | 52 244 279 297 | 141 154 215 338 |
| 62 109 190 201 | 22 131 256 349 | 55 294 296 298 |
| 111 162 190 227 | 47 52 339 346 | 80 109 272 364 |
| 189 272 288 302 | 50 288 342 388 | 43 206 287 363 |
| 1449 147 334 | 26 87 247 283 | 81 175 206 261 |
| 33 53 213 238 | 67 127 132 136 | 31 94 275 317 |
| 53 219 368 379 | 146 264 321 323 | 10 123 141 279 |
| 126 149 188 339 | 210 275 319 346 | 44 64 157 270 |
| 108 118 182 393 | 57 160 252 261 | 160 243 290 373 |
| 037 160 295 | 26 54 170 197 | 39 217 262 324 |
| 158 200 335 356 | 120 218 229 341 | 19 185 312 389 |
| 11 20 229 397 | 44 53 124 323 | 211 271 277 291 |
| 77 86 212 250 | 0 113 315 358 | 19 148 155 324 |
| 79 193 262 336 | 110 144 246 298 | 24 94 124 314 |
| 43 104 125 376 | 8991 99346 | 3 85 193 349 |
| 55 114 134 293 | 21 32 216 393 | 68 175 202 253 |
| 240 283 299 333 | 37 170 209 342 | 139 160 337 377 |
| 0 24 57 100 | 49 58 357 399 | 21 224 249 398 |
| 46 84 322 341 | 18 23 31 373 | 113 122 206 327 |
| 5 43 45 221 | 159 172 195 366 | 7 10 156 245 |
| 29 217 274 301 | 213 335 337 378 | 140 182 192 235 |
| 81 93 116 278 | 1 103 159 277 | 161 291 324 387 |
| 93 174 213 231 | 96 159 209 387 | 31 232 237 350 |
| 64 201 251 385 | 102 165 234 378 | 30 184 235 387 |
| 76 134 278 370 | 173 245 356 376 | 136 226 269 327 |
| 71 93 182 398 | 57 230 240 314 | 4 93 136 167 |
| 38 174 250 377 | 1 89 153 166 | 47 148 309 348 |
| 19 116 357 372 | 25 32 264 342 | 73 225 252 290 |
| 81 91 164 307 | 265 276 321 324 | 44 213 361 386 |
| 79 319 361 381 | 118 150 267 324 | 132 197 238 279 |
| 74 251 339 356 | 68 82 309 398 | 16 94 150 222 |
| 100 105 246 293 | 72 154 226 231 | 241 344 375 386 |
| 68 101 191 285 | 76 135 151 384 | 31 121 161 231 |
| 32 103 323 355 | 39 48 80 309 | 9 33 197 350 |
| 122 188 228 305 | 0 178 305 353 | 87 197 233 312 |
| 6 77 291 397 | 88 136 196 321 | 100 111 129 368 |
| 70 76 259 276 | 37 95 222 300 | 184 278 289 346 |
| 72 270 335 348 | 23 343 358 369 | 76 177 227 356 |
| 93 147 255 312 | 195 252 303 349 | 11 132 246 314 |
| 92 112 259 388 | 9 81 102 317 | 46 93 103 309 |

(continued)

| | | |
|---|---|---|
| 9 18 61 308 | 20 219 285 316 | 20 33 64 196 |
| 3 137 139 257 | 219 281 304 354 | 111 134 194 204 |
| 165 217 345 354 | 33 121 319 351 | 76 116 140 238 |
| 78 134 263 280 | 21 157 191 260 | 189 298 326 381 |
| 186 213 227 303 | 0 88 303 307 | 235 317 320 333 |
| 68 194 294 346 | 13 23 62 268 | 127 301 348 376 |
| 35 225 284 312 | 13 173 279 320 | 51 286 309 377 |
| 117 188 340 346 | 117 189 253 392 | 17 70 139 187 |
| 258 299 306 331 | 32 40 57 350 | 54 180 184 344 |
| 83 194 207 349 | 57 123 148 368 | 85 311 318 327 |
| 43 141 175 329 | 18 96 164 326 | 263 312 364 369 |
| 0 68 170 262 | 84 103 107 359 | 97 149 198 336 |
| 25 36 153 309 | 92 338 350 355 | 31 141 151 285 |
| 57 62 273 323 | 16 70 242 338 | 72 163 187 311 |
| 7 19 75 264 | 2074141 179 | 24 54 249 297 |
| 21 254 259 366 | 159 246 248 365 | 64 143 322 360 |
| 897 156 172 | 207 292 387 399 | 53 73 122 256 |
| 9 185 313 330 | 38 148 303 347 | 100 138 214 226 |
| 55 219 253 393 | 68 113 296 389 | 265 348 373 378 |
| 86 120 185 233 | 12 257 286 325 | 42 62 113 174 |
| 41 136 191 242 | 50 287 294 327 | 29 313 349 358 |
| 194 265 303 393 | 149 259 356 367 | 154 179 217 268 |
| 256 285 310 399 | 3 12178309 | 164 289 380 392 |
| 103 247 275 378 | 63 92 166 368 | 109 165 236 312 |
| 115 218 225 285 | 97 190 199 363 | 92 141 193 238 |
| 98 196 217 328 | 138692308 | 190 243 267 275 |
| 177 267 306 350 | 132 141 221 322 | 95 143 203 393 |
| 82 299 320 395 | 213 257 348 396 | 130 213 264 308 |
| 139 251 364 381 | 91 147 294 325 | 102 133 217 226 |
| 42 118 178 194 | 14 27 48 222 | 69 88 116 295 |
| 73 100 198 286 | 11 81 110 360 | 108 217 273 322 |
| 68 249 292 376 | 10 50 357 393 | 26 287 306 343 |
| 13 216 221256 | 35 89 248 252 | 8 18 136 152 |
| 127 138 177 398 | 655319345 | 110 240 245 334 |
| 20 69 239 264 | 107 116 223 271 | 225 255 278 310 |
| 3 126 132 163 | 168 240 261 384 | 63 168 170 303 |
| 66 88 169 271 | 54 204 295 351 | 8 17 255 314 |
| 88 197 201 387 | 3 51 146 299 | 28 92 98 200 |
| 1 51 135 149 | 74 184 307 361 | 112 201 244 392 |
| 257 294 331 356 | 9 202 272 387 | 134 216 344 383 |
| 204 260 288 294 | 106 198 281 329 | 21 97 115 396 |
| 45 144 185 383 | 36 105 225 236 | 28 69 120 380 |
| 173 310 329 362 | 90 139 183 299 | 34 259 267 314 |
| 15 165 305 348 | 152 160 292 354 | 55 72 87 223 |
| 27 66 85 182 | 11 115 227 236 | 43 180 185 252 |
| 47 235 238 246 | 152 202 211 373 | 23 113 133 277 |
| 230 276 293 367 | 4 173 346 374 | 258 285 347 350 |
| 246 253 318 399 | 60 109 199 348 | 22 132 258 368 |
| 12 78 90 369 | 27 89 214 388 | 65 124 129 325 |
| 17 93 96 102 | 77 79 83 289 | 95 105 111 385 |
| 109 162 318 360 | 119 236 323 383 | 109 233 250 302 |

(continued)

| | | |
|---|---|---|
| 22 83 151 290 | 1 44 271 372 | 8 33 80 318 |
| 141 191 240 266 | 25 42 104 215 | 51 253 281 288 |
| 25 90 138 390 | 144 153 357 362 | 209 237 346 391 |
| 81 113 265 382 | 133 153 273 383 | 12 198 221 269 |
| 88 142 210 283 | 152 174 269 355 | 9 141 229 306 |
| 10 40 43 140 | 107 193 210 320 | 0 114 219 300 |
| 2 195 268 328 | 194 298 317 331 | 242 289 318 335 |
| 117 240 257 374 | 22 112 139 222 | 41 90 163 215 |
| 298 332 350 365 | 147 152 221 365 | 65 80 99 167 |
| 60 122 240 313 | 2048 130 353 | 269 296 303 356 |
| 157 215 274 397 | 58 100 125 172 | 45 106 232 346 |
| 11 41 164 274 | 79 181 242 313 | 86 195 293 391 |
| 67 76 92 104 | 174 254 304 321 | 140 193 245 321 |
| 19 192 305 344 | 70 129 283 385 | 88 150 183 380 |
| 23 35 125 224 | 18 79 296 345 | 230 253 315 373 |
| 152 163 352 385 | 14 25 34 52 | 53 184 258 263 |
| 40 161 165 329 | 31 88 212 226 | 17 79 261 286 |
| 113 215 245 378 | 26 53 123 165 | 94 293 302 397 |
| 80 168 262 382 | 101 108 248 328 | 170 218 358 376 |
| 81 136 165 239 | 49 115 190 395 | 61 246 287 292 |
| 2 42 248 323 | 23 119 139 282 | 61 162 245 303 |
| 111 127 157 330 | 27 206 209 324 | 25 286 333 355 |
| 79 125 239 341 | 203 221 332 356 | 159 241 263 354 |
| 147 172 187 397 | 181 190 288 379 | 134 186 305 327 |
| 230 245 277 352 | 38 73 249 368 | 33 38 283 301 |
| 49 202 350 381 | 45 49 264 394 | 1744 159 398 |
| 34 56 167 242 | 89 112 218 316 | 108 167 174 374 |
| 36 58 61 83 | 144 186 297 343 | 90 105 172 257 |
| 107 110 133 251 | 152 177 233 237 | 93 165 180 353 |
| 100 245 295 330 | 74 171 223 334 | 137 289 296 386 |
| 16 71 175 397 | 4 16 44 89 | 241 273 276 359 |
| 106 206 229 236 | 103 165 177 358 | 44 94 211 286 |
| 177 308 371 387 | 53 217 342 383 | 166 184 204 226 |
| 89 122 207 362 | 58 88 126 370 | 98 281 357 389 |
| 3 166 190 305 | 4 214 243 383 | 41 107 187 298 |
| 155 171 289 336 | 5 96 155 354 | 19 47 379 399 |
| 34 37 293 301 | 7 61 214 237 | 1 16 272 296 |
| 143 189 255 338 | 90 241 261 367 | 107 203 283 322 |
| 38 75 137 166 | 39 161 202 206 | 77 245 266 390 |
| 6292 124 366 | 101 132 135 250 | 29 166 345 364 |
| 73 83 105 136 | 117 191 213 352 | 61 229 356 361 |
| 69 134 200 366 | 132 233 270 303 | 70 105 229 250 |
| 179 324 366 386 | 16 251 266 370 | 268 334 344 368 |
| 72 82 188 192 | 41 45 60 99 | 78 82 283 393 |
| 100 120 189 375 | 182 197 276 331 | 7 299 327 334 |
| 244 252 318 329 | 40 257 262 322 | 47 82 117 126 |
| 3 105 116 203 | 148 208 332 352 | 86 100 337 379 |
| 280 282 288 365 | 127 159 253 290 | 299 347 372 375 |
| 38 196 330 369 | 273 289 325 341 | 150 156 299 302 |
| 20 31 113 381 | 95 145 231 297 | 145 252 294 377 |
| 56 173 205 390 | 70 110 225 313 | 155 218 250 392 |

(continued)

| | | |
|---|---|---|
| 2 30 165 366 | 50 112 166 302 | 131 172 250 278 |
| 41 75 169 302 | 68 97 128 218 | 17 64 107 195 |
| 210 271 330 334 | 90 264 269 280 | 26 55 142 181 |
| 106 181 327 342 | 22 47 353 387 | 33 71 91 112 |
| 101 103 340 368 | 0 137 143 167 | 13 132 247 391 |
| 44 196 198 280 | 21 162 195 339 | 22 208 226 392 |
| 39 148 192 385 | 24 225 233 338 | 56 60 158 164 |
| 37 130 182 207 | 177 225 232 281 | 20 105 120 199 |
| 5 242 262 316 | 77 149 241 310 | 133 232 236 341 |
| 20 171 259 396 | 319 325 363 374 | 90 107 293 370 |
| 25 288 338 361 | 77 251 308 379 | 17 32 254 263 |
| 12 290 362 367 | 183 203 290 330 | 8 173 238 266 |
| 153 236 304 330 | 158 246 275 352 | 30 167 169 391 |
| 12 144 261 329 | 78 99 210 238 | 43 213 328 362 |
| 33 92 106 173 | 222 271 380 393 | 73 231 244 282 |
| 68 89 159 308 | 79 107 201 351 | 71 221 245 253 |
| 9 23 41 301 | 66 90 275 287 | 215 225 258 335 |
| 109 160 278 387 | 65 219 247 398 | 46 87 263 384 |
| 138 235 241 356 | 16 203 207 237 | 81 96 282 338 |
| 225 256 321 332 | 101 216 333 357 | 192 222 306 353 |
| 32 42 253 275 | 2 39 326 373 | 8115292305 |
| 9 199 219 225 | 51 151 305 341 | 36 170 186 260 |
| 116 328 345 395 | 6 25 30 130 | 10 85 212 300 |
| 128 159 161 207 | 2 91 146 227 | 5 129 198 365 |
| 111 306 363 373 | 46 141 273 298 | 19 107 153 308 |
| 174 2S6 368 381 | 157 331 374 385 | 10 57 98 215 |
| 18 104 115 317 | 172 223 237 258 | 181 211 228 339 |
| 102 115 140 394 | 15 93 128 250 | 62 89 163 295 |
| 91 96 128 327 | 94 261 312 341 | 43 77 113 143 |
| 97 99 300 385 | 167 186 202 372 | 125 149 196 218 |
| 40 150 229 316 | 8 29 355 393 | 83 147 183 279 |
| 12431 322 359 | 36 126 155 373 | 62 145 180 397 |
| 21 221 286 301 | 145 195 227 333 | 84 280 331 360 |
| 27 88 147 216 | 45 206 344 369 | 114 190281 359 |
| 10 124 128 309 | 8 166 301 397 | 69 129 168 187 |
| 57 131 209 296 | 1147 141 184 | 119 144 180 249 |
| 230 237 264 371 | 7 112 256 377 | 74 218 308 |
| 28 118 231 283 | 108 300 310 312 | 217 251 269 390 |
| 5 114 230 309 | 208 218 364 378 | 189 200 275 372 |
| 122 189 204 251 | 53 114 278 291 | 157 218 296 363 |
| 74 151 203 218 | 131 138 201 365 | 52 110 151 319 |
| 69 270 288 359 | 225 279 371 378 | 30 131 153 174 |
| 22 49 291 383 | 122 275 376 395 | 28 32 182 198 |
| 80 90 174 249 | 169 217 239 357 | 56 263 316 328 |
| 182 310 314 318 | 18 65 128 288 | 87 168 275 343 |
| 115 254 336 399 | 6 62 86 198 | 24 31 131 148 |
| 42 63 135 343 | 37 80 119 211 | 166 203 208 231 |
| 46 232 8 391 | 0 46 139 339 | 126 170 224 369 |
| 2427 171 183 | 0 30 216 306 | 20 78 193 213 |
| 237 293 322 352 | 82 152 277 367 | 123 180 253 323 |
| 81 90 223 363 | 23 178 350 366 | 208 229 271 386 |

(continued)

| | | |
|---|---|---|
| 71 85 128 380 | 121 212 243 384 | 1 52 116 383 |
| 159 309 314 334 | 257 284 326 382 | 13 55 71 106 |
| 17 117 315 379 | 57 138 311 343 | 7 306 347 364 |
| 87 120 206 267 | 295 318 322 377 | 145 163 197 228 |
| 67 116 188 349 | 78 343 373 377 | 66 97 212 320 |
| 63 232 338 365 | 79 89 131 254 | 133 176 282 305 |
| 178 272 327 392 | 61 74 304 382 | 22 187 205 372 |
| 19 35 204 386 | 3070 168253 | 102 160 180 258 |
| 194 235 289 345 | 64 156 306 332 | 164 197 311 398 |
| 29 50 154 315 | 162 197 255 275 | 75 119 186 254 |
| 6 15 65 396 | 23 82 144 396 | 6 45 123 126 |
| 30 108 341 399 | 78 93 95 275 | 69 241 268 274 |
| 217 276 326 347 | 145 169 211 278 | 15 324 3711399 |
| 160 237 274 285 | 29 163 300 320 | 62 232 264 373 |
| 173 248 262 348 | 33 147 219 391 | 103 106 146 344 |
| 52 65 218 351 | 199 214 265 280 | 134 268 29 398 |
| 135 140 253 366 | 62 133 156 219 | 120 220 250 354 |
| 5 81 176 260 | 31 34 72 115 | 115 208 355 398 |
| 58 215 326 364 | 246 260 267 286 | 74 190 343 352 |
| 76 87 102 315 | 7 266 309 337 | 258 325 332 371 |
| 98 131 259 332 | 24 69 142 394 | 14 256 347 353 |
| 15 30 35 55 | 98 138 228 351 | 24 33 122 234 |
| 0 122 269 346 | 72 181 336 355 | 98 272 300 342 |
| 38 162 311 373 | 12 47 160 172 | 210 221 268 337 |
| 143 313 329 340 | 84 178 230 343 | 8 94 154 347 |
| 80 260 316 348 | 80 238 321 376 | 195 285 321 327 |
| 44 158 220 292 | 170 213 331 367 | 12 51 54 354 |
| 117 241 295 363 | 12 136 274 326 | 16 41 149 389 |
| 187 321 355 378 | 13 51 96 147 | 55 66 206 297 |
| 167 226 281 351 | 23 264 334 346 | 129 202 214 285 |
| 0 200 309 384 | 29 122 183 356 | 73 96 104 310 |
| 36 171 193 328 | 78 287 330 349 | 55 200 270 318 |
| 107 178 228 240 | 42 69 131 198 | 58 120 150 217 |
| 80 146 156 375 | 36 43 189 216 | 58 279 339 397 |
| 75 90 290 312 | 44 142 195 344 | 60 180 247 308 |
| 2055 131 215 | 40 147 260 330 | 48 127 213 356 |
| 99 127 231 344 | 125 325 379 387 | 62 128 291 329 |
| 156 176 301 313 | 90 111 126 301 | 26 35 127 323 |
| 41 146 247 290 | 113 177 226 273 | 77 144 286 296 |
| 49 52 61 76 | 96 172 181218 | 10 47 192 259 |
| 24 74 310 326 | 17 124 154 373 | 122 196 210 329 |
| 56 196 212 332 | 87 285 306 376 | 63 162 235 268 |
| 76 205 335 385 | 83 163 173 299 | 25 45 218 310 |
| 75 101 209 349 | 65 87 245 333 | 67 336 354 393 |
| 28 172 242 294 | 161 267 284 293 | 16 278 347 381 |
| 1871 267297 | 1 29 54 379 | 14 39 209 395 |
| 84 115 233 384 | 141 170 183 232 | 21 55 85 304 |
| 63 139 216 325 | 5 40 167 238 | 128 135 194 325 |
| 23 64 310 348 | 15 44 95 239 | 116 159 258 341 |
| 63 130 188 352 | 13 75 152 188 | 125 132 210 219 |
| 2345 160 165 | 216 224 305 331 | 60 67 150 203 |

(continued)

| | | |
|---|---|---|
| 42 114 382 399 | 2993 197 381 | 18 60 167 328 |
| 25 207 339 365 | 21 222 282 284 | 5 112 179 381 |
| 16 334 374 398 | 175 193 361 372 | 288 317 324 389 |
| 86 251 274 277 | 54 69 298 308 | 43 320 334 382 |
| 157 166 297 316 | 93 169 209 328 | 5 29 145 281 |
| 171 200 230 265 | 39 59 334 391 | 25 124 232 345 |
| 34 107 325 364 | 108 254 340 376 | 11 119 339 359 |
| 71 220 227 330 | 141 246 264 388 | 5 36 231 316 |
| 177 263 277 344 | 96 267 362 392 | 15 138 354 389 |
| 75 138 262 293 | 131 234 291 330 | 25 82 136 180 |
| 189 300 366 377 | 4 168 220 235 | 20 103 167 266 |
| 147 175 296 320 | 130 195 216 367 | 112 292 359 371 |
| 2 51 145 208 | 108 148 290 302 | 184 201 240 328 |
| 126 271 310 351 | 85 214 362 395 | 77 160 307 339 |
| 144 197 277 360 | 48 100 118 346 | 74 147 280 389 |
| 2835 115289 | 91 104 355 358 | 127 149 358 387 |
| 54 108 270 279 | 176 342 351 390 | 50 9 117 185 |
| 11 189 212 220 | 65 183 369 376 | 14 26 72 304 |
| 123 135 226 372 | 60 169 292 350 | 51 162 194 387 |
| 83 86 149 386 | 44 169 240 362 | 94 245 273 287 |
| 26 95 121 163 | 146 187 293 319 | 26 177 205 314 |
| 30 54 178 315 | 198 219 343 380 | 14 92 385 389 |
| 136 301 341 365 | 148 188 256 304 | 111 211 366 390 |
| 21 59 265 299 | 171 189 266 341 | 27 71 110 327 |
| 111 154 282 297 | 94 108 244 288 | 99 257 359 389 |
| 6 74 290 349 | 16 42 200 250 | 124 295 372 397 |
| 121 142 174 236 | 2 64 193 399 | 12 43 117 356 |
| 108 129 152 261 | 129 172 276 379 | 65 117 136 354 |
| 152 164 205 377 | 26 176 234 319 | 39 67 191 212 |
| 144 281 332 335 | 118 135 205 312 | 80 166 176 358 |
| 92 244 311 326 | 115 176 290 359 | 99 208 353 361 |
| 66 128 170 221 | 9 143 188 374 | 32 46 104 222 |
| 21 109 174 397 | 96 186 247 353 | 4 25 72 203 |
| 5 154 201 239 | 30 72 320 388 | 2 124 130 262 |
| 80 183 261 293 | 17 137 186 193 | 28 113 210 232 |
| 18 143 333 392 | 34 229 265 284 | 66 77 158 268 |
| 13 139 155 230 | 129 207 282 287 | 61 98 202 330 |
| 145 156 300 327 | 68 118 275 305 | 47 67 181 247 |
| 118 153 171 366 | 153 172 249 307 | 51 204 209 307 |
| 15 152 331 364 | 106 179 212 378 | 125 198 289 301 |
| 161 171 307 317 | 22 48 105 347 | 136 214 216 263 |
| 4956 127185 | 98 137 346 379 | 97 270 314 338 |
| 104 168 283 305 | 41 98 165 232 | 78 127 215 226 |
| 199 202 343 399 | 54 63 99 123 | 27 242 348 357 |
| 15 164 192 273 | 81 213 315 394 | 94 181 191 363 |
| 62 199 222 228 | 38 66 87 191 | 7 91 93 348 |
| 67 94 166 256 | 71 121 294 396 | 60 193 267 333 |
| 8 227 250 321 | 109 200 345 375 | 185 237 272 381 |
| 91 121 295 324 | 33 70 217 266 | 15 52 166 225 |
| 3 16 308 340 | 11 111 210 240 | 27 100 126 275 |
| 143 157 307 395 | 261 271 290 396 | 70 96 163 333 |

(continued)

| | | |
|---|---|---|
| 36 77 116 340 | 190 225 298 369 | 11 175 273 282 |
| 3 98 101 125 | 16 140 227 352 | 14 212 392 398 |
| 39 151 364 377 | 118 183 262 383 | 91 105 300 382 |
| 194 227 231 267 | 17 218 260 350 | 4 79 232 370 |
| 59 200 206 389 | 50 56 278 351 | 21 75 158 347 |
| 21 106 287 389 | 1536 150 280 | 331 341 343 386 |
| 33 268 340 387 | 18 107 151 176 | 0 103 163 270 |
| 140 150 395 398 | 22 188 244 337 | 7 95 171 326 |
| 88 352 360 367 | 72 186 302 350 | 16 24 49 133 |
| 55 91 145 168 | 65 145 221 239 | 58 242 363 390 |
| 126 130 181 323 | 52 117 331 393 | 8 236 254 290 |
| 34 120 227 316 | 7 37 265 285 | 50 83 140 370 |
| 237 337 355 394 | 56 283 338 382 | 233 258 340 364 |
| 34 186 219 313 | 78 217 337 351 | 63 289 292 313 |
| 280 330 340 375 | 6 247 249 370 | 231 245 336 342 |
| 76 230 354 378 | 1 161 241 255 | 35 38 246 299 |
| 5 178 293 297 | 101 166 183 220 | 104 246 249 281 |
| 142 223 234 381 | 99 198 326 335 | 161 248 285 325 |
| 48 239 260 399 | 105 234 340 384 | 13 21 192 220 |
| 58 270 336 360 | 60 233 242 397 | 82 89 200 209 |
| 24 123 271 347 | 207 215 223 293 | 8 264 313 368 |
| 12 76 137 280 | 233 279 351 380 | 11 26 242 286 |
| 107 226 302 367 | 83 106 188 311 | 37 248 303 388 |
| 175 186 208 366 | 97 185 361 392 | 64 187 324 392 |
| 209 216 230 243 | 8 47 113 153 | 156 247 278 334 |
| 73 241 250 260 | 194 233 361 377 | 130 235 319 390 |
| 181 187 235 239 | 88 202 284 394 | 0 108 120 213 |
| 63 193 300 329 | 29 118 285 380 | 11 93 146 235 |
| 291 332 354 396 | 96 154 312 383 | 96 255 374 376 |
| 19 103 260 383 | 19 250 318 359 | 85 146 204 366 |
| 5 303 328 375 | 32 282 289 334 | 146 254 365 391 |
| 131 237 298 384 | 56 272 294 303 | 114 148 151 373 |
| 103 183 281 286 | 10 68 72 210 | 60 121 145 343 |
| 5 224 263 358 | 184 261 382 386 | 112 195 277 296 |
| 197 199 247 382 | 202 204 315 342 | 29 302 310 334 |
| 18 228 332 344 | 66 102 195 207 | 38 156 251 280 |
| 16 26 57 68 | 97 243 272 301 | 130 209 249 266 |
| 2 158 259 384 | 92 128 156 304 | 43 161 250 322 |
| 128 181 371 398 | 68 313 385 390 | 7 168 182 185 |
| 98 179 247 319 | 13 32 49 271 | 15 45 189 286 |
| 41 71 138 326 | 4 80 123 277 | 191 205 301 305 |
| 175 244 301 317 | 89 135 243 375 | 155 235 282 299 |
| 81 15 226 371 | 88 372 381 388 | 40 114 194 372 |
| 125 202 226 309 | 66 108 222 274 | 249 263 323 372 |
| 115 169 276 298 | 28 59 164 167 | 36 214 252 380 |
| 192 268 296 391 | 201 204 313 324 | 176 201 258 373 |
| 31 167 220 223 | 73 311 388 397 | 102 208 340 379 |
| 39 241 358 382 | 109 186 243 261 | 85 161 240 262 |
| 67 112 159236 | 116 125 276 398 | 5 17 199 339 |
| 71 180 208 266 | 58 185 287 293 | 150 230 306 341 |
| 59 143 248 394 | 40 203 279 314 | 46 123 204 318 |

(continued)

| | | |
|---|---|---|
| 99 128 223 388 | 46 50 86 255 | 71 130 143 271 |
| 6 192 221 351 | 23 48 109 120 | 208 268 365 396 |
| 129 238 257 378 | 236 297 325 333 | 257 263 336 395 |
| 29 192 252 392 | 123 155 320 384 | 218 267 334 360 |
| 6 110 177 269 | 36 67 169 274 | 53 74 255 302 |
| 29 79 205 241 | 54 102 191 239 | 104 175 302 311 |
| 233 246 325 331 | 8 109 198 391 | 228 338 360 369 |
| 11 211 321 384 | 143 176 238 370 | 835 112 394 |
| 144 282 337 386 | 39 41 105 208 | 39 130 336 365 |
| 33 79 327 385 | 126 197 342 357 | 13 170 198 378 |
| 30 110 179 321 | 9 40 191 384 | 56 156 162 181 |
| 86 133 234 284 | 51 148 207 270 | 47 95 104 272 |
| 54 58 72 289 | 49 114 243 360 | 9 291 333 362 |
| 22 145 269 373 | 60 87 303 370 | 121 128 193 322 |
| 81 172 211 381 | 138 190 248 283 | 159 276 311 392 |
| 59 246 252 255 | 78 97 139 144 | 1542 105 267 |
| 34 11 207 286 | 177 180 244 272 | 4 23 202 388 |
| 69 100 222 231 | 44 123 243 287 | 23 61 260 307 |
| 14 150 387 396 | 122 211 304 388 | 42 124 355 380 |
| 17 73 228 248 | 70 117 278 332 | 124 259 374 386 |
| 29 193 232 259 | 31 85 343 394 | 136 140 207 317 |
| 40 148 359 374 | 47 133 244 312 | 9 278 280 325 |
| 38 281 316 327 | 20 144 299 368 | 4 19 59 360 |
| 7087 100 395 | 25 84 335 395 | 21 79 94 356 |
| 26 231 295 369 | 102 199 213 283 | 26 158 345 353 |
| 214 234 269 288 | 64 164 169 224 | 95 172 261 374 |
| 77 154 320 365 | 50 152 224 276 | 27 119 364 373 |
| 27 76 86 155 | 42 184 390 398 | 35 245 335 374 |
| 65 139 175 240 | 1 73 349 396 | 139 162 184 228 |
| 33 130 223 286 | 238 317 354 385 | 53 84 214 363 |
| 215 271 317 344 | 46 70 296 379 | 17 153 242 386 |
| 30 137 274 313 | 70 95 306 391 | 83 88 180 363 |
| 68 169 256 369 | 178 187 249 316 | 153 371 374 393 |
| 30 119 206 394 | 37 52 162 307 | 142 161 286 312 |
| 224 325 365 380 | 173 211 237 344 | 34 111 221 243 |
| 50 178 188 274 | 41 114 210 233 | 40 66 91 391 |
| 2 56 169 225 | 102 202 287 354 | 55 120 165 209 |
| 4375 167 296 | 136 185 223 303 | 4 28 46 292 |
| 28 131 274 304 | 86 265 287 355 | 149 222 244 357 |
| 107 263 309 385 | 11 66 131 255 | 190 339 362 364 |
| 101 238 310 395 | 124 147 319 392 | 10 67 187 338 |
| 35 58 238 345 | 46 67 152 380 | 2 132 168 263 |
| 4361 106 391 | 64 82 111 312 | 9 63 294 305 |
| 86 113 161 390 | 78 123 264 317 | 26 60 148 224 |
| 35 316 329 376 | 24 45 85 295 | 59 157 188 224 |
| 37 161 224 306 | 118 141 244 255 | 139 220 320 349 |
| 14 53 98 269 | 17 164 229 252 | 69 202 336 385 |
| 179 207 236 269 | 27 132 134 179 | 20 92 313 331 |
| 10 163 205 369 | 173 216 220 247 | 44 79 316 392 |
| 31 92 162 396 | 246 306 375 384 | 104 177 254 335 |
| 85 268 314 345 | 75 160 187 263 | 4 199 234 308 |

(continued)

| | | |
|---|---|---|
| 1 31 249 319 | 171 236 329 389 | 76 139 192 332 |
| 35 56 281 333 | 58 178 196 380 | 1 252 322 331 |
| 137 199 223 376 | 171 203 256 370 | 89 217 352 378 |
| 52 320 338 362 | 5 134 277 330 | 83 156 175 211 |
| 65 224 307 390 | 110 153 320 336 | 75 132 341 364 |
| 146 310 346 384 | 24 93 369 383 | 78 106 204 272 |
| 101 138 193 307 | 35 100 244 361 | 65 159 214 284 |
| 234 314 342 394 | 327 345 369 396 | 141 161 342 353 |
| 19 109 127 214 | 27 37 185 277 | 336 375 381 397 |
| 40 80 132 196 | 257 259 321 362 | 143 260 291 302 |
| 183 213 229 249 | 23 253 280 370 | 84 298 339 375 |
| 105 228 232 238 | 13 44 99 224 | 219 234 357 374 |
| 64 278 290 357 | 57 69 114 224 | 01 18 292 328 |
| 20 116 173 251 | 70 154 185 352 | 19 119 226 387 |
| 97 261 308 393 | 34 269 338 367 | 115 167 294 319 |
| 20 100 146 165 | 77 170 234 326 | 53 222 233 236 |
| 67 84 164 376 | 138 171 192 269 | 18 52 63 182 |
| 155 260 300 352 | 173 192 284 371 | 79 102 148 311 |
| 116 118 147 233 | 68 155 164 353 | 140 270 351 369 |
| 61 174 328 371 | 4 22 201 212 | 91 255 289 389 |
| 30 60 155 368 | 206 234 259 270 | 163 285 330 338 |
| 39 142 169 232 | 35 168 176 389 | 237 251 312 359 |
| 54 76 318 358 | 103 162 351 370 | 39 186 288 301 |
| 196 341 352 391 | 49 59 102 212 | 29 188 211 367 |
| 61 63 333 350 | 155 192 270 287 | 269 298 391 397 |
| 42 130 307 331 | 4 81 95 119 | 85 95 292 307 |
| 25 190 224 282 | 135 138 200 301 | 72 150 266 314 |
| 57 238 375 393 | 11 32 294 357 | 101 199 253 359 |
| 5 158 186 355 | 10 73 84 173 | 1841 259 368 |
| 83 110 385 399 | 25 48 97 145 | 122 125 185 324 |
| 48 154 166 308 | 7 223 280 366 | 58 294 318 365 |
| 2 75 288 340 | 83 137 247 276 | 84 210 216 235 |
| 86 223 248 264 | 31 56 117 325 | 54 142 147 355 |
| 67 135 158 350 | 211 281 307 358 | 73 91 174 353 |
| 80 133 345 351 | 49 118 211 372 | 15 48 292 323 |
| 51 195 265 335 | 70 179 221 371 | 4 62 67 126 |
| 63 117 159 196 | 38 260 266 388 | 109 129 191 203 |
| 13 16 37 143 | 142 222 253 335 | 143 154 168 205 |
| 24 75 127 304 | 69 281 347 371 | 109 153 189 370 |
| 34 142 182 363 | 59 264 271 348 | 14 110 338 381 |
| 10 198 303 308 | 175 255 277 357 | 101 142 257 376 |
| 146 258 273 361 | 51 97 374 399 | 93 129 359 394 |
| 113 132 220 359 | 108 223 317 360 | 133 137 142 314 |
| 39 179 252 274 | 82 125 216 228 | 187 215 269 294 |
| 6 176 199 318 | 134 154 172 317 | 116 121 300 363 |
| 33 55 95 124 | 49 65 74 157 | 57 251 267 386 |
| 134 228 283 329 | 3 112 266 356 | 14 126 335 379 |
| 75 175 339 371 | 81 204 254 262 | 31 133 250 268 |
| 78 89 202 322 | 3 113 263 332 | 9 183 241 342 |
| 85 197 310 390 | 100 151 205 240 | 37 164 279 324 |
| 59 112 305 323 | 95 125 180 303 | 118 130 187 270 |

17

(continued)

| | | |
|---|---|---|
| 154 163 287 305 | 234 292 306 352 | 135 169 182 319 |
| 83 195 206 264 | 149 227 349 355 | 6 149 204 220 |
| 45 209 255 311 | 111 142 267 321 | 63 150 214 259 |
| 54 182 261 302 | 27 203 228 361 | 19 65 348 388 |
| 128 190 241 384 | 52 277 309 390 | 15 46 151 383 |
| 7 48 66 82 | 33 57 284 302 | 22 160 227 230 |
| 173 315 372 382 | 35 50 66 219 | 124 166 279 317 |
| 41 49 117 320 | 2227 149 215 | 45 130 237 361 |
| 45 82 120 133 | 13 28 84 206 | 6 189 316 347 |
| 642 195 295 | 59 108 337 349 | 74 135 142 311 |
| 171 201 344 377 | 73 171 273 345 | 85 153 177 222 |
| 94 179 205 344 | 68 140 200 363 | 120 154 210 237 |
| 32 144 219 315 | 38 111 233 358 | 0 98 291 388 |
| 226 257 333 386 | 157 289 328 372 | 32 259 287 333 |
| 24 102 182 375 | 160 188 284 327 | 184 314 389 397 |
| 49 86 123 175 | 137 304 349 374 | 101 189 296 383 |
| 62 151 266 298 | 140 168 204 341 | 126 160 235 240 |
| 272 323 339 367 | 132 223 298 336 | 111 120 212 288 |
| 99 160 273 330 | 71 114 184 200 | 10 174 209 291 |
| 194 274 324 368 | 60 135 323 399 | 112 114 186 239 |
| 51 127 158 191 | 9 38 179 245 | 164 179 304 346 |
| 2 98 164 393 | 114 157 229 366 | 90 127 252 284 |
| 90 108 149 315 | 229 297 323 342 | 53 173 282 333 |
| 8 122 129 299 | 24 36 89 106 | 82 87 98 354 |
| 8 48 64 210 | 101 134 140 381 | 77 106 138 345 |
| 56 106 207 240 | 50 148 194 257 | 74 329 360 366 |
| 48 87 212 340 | 1 222 340 378 | 167 322 332 395 |
| 38 231 288 394 | 67 155 220 365 | 52 88 276 294 |
| 137 353 378 393 | 15 156 210 262 | 47 199 299 391 |
| 119 150 272 355 | 53 125 134 231 | 3 219 275 297 |
| 64 92 190291 | 192 337 357 360 | 3 30 375 378 |
| 4 51 121 215 | 170 203 216 266 | 110 134 158 282 |
| 119 171 229 253 | 2 71 74 362 | 151 188 359 388 |
| 65 357 363 370 | 40 97 101 356 | 191 199 304 333 |
| 83 172 197 280 | 54 117 145 201 | 42 191 274 383 |
| 27 131 360 396 | 34 81 147 326 | 51 99 384 394 |
| 77 136 150 309 | 5 121 256 311 | 146 343 367 376 |
| 3 121 179230 | 14 176 272 383 | 153 247 284 375 |
| 10 104 152 326 | 283 297 340 396 | 36 133 204 243 |
| 64 134 178 182 | 7 36 307 320 | 110 224 265 277 |
| 214 300 353 386 | 114 241 271 315 | 86 129 319 371 |
| 110 254 268 346 | 96 179 249 302 | 103 127 201 336 |
| 272 304 337 347 | 7 9 170 394 | 39 50 247 256 |
| 37 165 235 262 | 46 284 308 388 | 119 165 230 370 |
| 1 36 234 297 | 104 158 332 362 | 21 82 248 311 |
| 84 137 239 315 | 21 22 | 79 80 |
| 1 155 239 268 | 22 23 | 80 81 |
| 265 278 329 342 | 23 24 | 81 82 |
| 18 118 234 242 | 24 25 | 82 83 |
| 135 189 337 353 | 25 26 | 83 84 |
| 18 28 123 159 | 26 27 | 84 85 |

(continued)

| | | |
|---|---|---|
| 26 44 88 267 | 27 28 | 85 86 |
| 12 50 103 251 | 28 29 | 86 87 |
| 144 242 244 372 | 29 30 | 87 88 |
| 53 181 221 229 | 30 31 | 88 89 |
| 46 89 180 281 | 31 32 | 89 90 |
| 3 53 285 382 | 32 33 | 90 91 |
| 175 184 205 209 | 33 34 | 91 92 |
| 94 208 276 349 | 34 35 | 92 93 |
| 1437 131 266 | 35 36 | 93 94 |
| 135 227 367 392 | 36 37 | 94 95 |
| 13 59 103 207 | 37 38 | 95 96 |
| 48 78 84 243 | 38 39 | 96 97 |
| 94 252 262 306 | 39 40 | 97 98 |
| 168 316 324 380 | 40 41 | 98 99 |
| 196 255 260 394 | 41 42 | 99 100 |
| 11 105 178 243 | 42 43 | 100 101 |
| 19 122 177 339 | 43 44 | 101 102 |
| 64 203 304 319 | 44 45 | 102 103 |
| 12 174 194 208 | 45 46 | 103 104 |
| 46 52 271 377 | 46 47 | 104 105 |
| 62 149 169 353 | 47 48 | 105 106 |
| 133 205 239 387 | 48 49 | 106 107 |
| 174 206 285 292 | 49 50 | 107 108 |
| 14 43 99 137 | 50 51 | 108 109 |
| 87 111 371 377 | 51 52 | 109 110 |
| 73 137 177 261 | 52 53 | 110 111 |
| 10 105 184 352 | 53 54 | 111 112 |
| 126 286 347 390 | 54 55 | 112 113 |
| 72 91 148 196 | 55 56 | 113 114 |
| 12 162 292 363 | 56 57 | 114 115 |
| 6 112 273 399 | 57 58 | 115 116 |
| 0 1 | 58 59 | 116 117 |
| 1 2 | 59 60 | 117 118 |
| 2 3 | 60 61 | 118 119 |
| 3 4 | 61 62 | 119 120 |
| 4 5 | 62 63 | 120 121 |
| 5 6 | 63 64 | 121 122 |
| 6 7 | 64 65 | 122 123 |
| 7 8 | 65 66 | 123 124 |
| 8 9 | 66 67 | 124 125 |
| 9 10 | 67 68 | 125 126 |
| 10 11 | 68 69 | 126 127 |
| 11 12 | 69 70 | 127 128 |
| 12 13 | 70 71 | 128 129 |
| 13 14 | 71 72 | 129 130 |
| 14 15 | 72 73 | 130 131 |
| 15 16 | 73 74 | 131 132 |
| 16 17 | 74 75 | 132 133 |
| 17 18 | 75 76 | 133 134 |
| 18 19 | 76 77 | 134 135 |
| 19 20 | 77 78 | 135 136 |

(continued)

| | | |
|---|---|---|
| 20 21 | 78 79 | 136 137 |
| 137 138 | 195 196 | 253 254 |
| 138 139 | 196 197 | 254 255 |
| 139 140 | 197 198 | 255 256 |
| 140 141 | 198 199 | 256 257 |
| 141 142 | 199 200 | 257 258 |
| 142 143 | 200 201 | 258 259 |
| 143 144 | 201 202 | 259 260 |
| 144 145 | 202 203 | 260 261 |
| 145 146 | 203 204 | 261 262 |
| 146 147 | 204 205 | 262 263 |
| 147 148 | 205 206 | 263 264 |
| 148 149 | 206 207 | 264 265 |
| 149 150 | 207 208 | 265 266 |
| 150 151 | 208 209 | 266 267 |
| 151 152 | 209 210 | 267 268 |
| 152 153 | 210 211 | 268 269 |
| 153 154 | 211 212 | 269 270 |
| 154 155 | 212 213 | 270 271 |
| 155 156 | 213 214 | 271 272 |
| 156 157 | 214 215 | 272 273 |
| 157 158 | 215 216 | 273 274 |
| 158 159 | 216 217 | 274 275 |
| 159 160 | 217 218 | 275 276 |
| 160 161 | 218 219 | 276 277 |
| 161 162 | 219 220 | 277 278 |
| 162 163 | 220 221 | 278 279 |
| 163 164 | 221 222 | 279 280 |
| 164 165 | 222 223 | 280 281 |
| 165 166 | 223 224 | 281 282 |
| 166 167 | 224 225 | 282 283 |
| 167 168 | 225 226 | 283 284 |
| 168 169 | 226 227 | 284 285 |
| 169 170 | 227 228 | 285 286 |
| 170 171 | 228 229 | 286 287 |
| 171 172 | 229 230 | 287 288 |
| 172 173 | 230 231 | 288 289 |
| 173 174 | 231 232 | 289 290 |
| 174 175 | 232 233 | 290 291 |
| 175 176 | 233 234 | 291 292 |
| 176 177 | 234 235 | 292 293 |
| 177 178 | 235 236 | 293 294 |
| 178 179 | 236 237 | 294 295 |
| 179 180 | 237 238 | 295 296 |
| 180 181 | 238 239 | 296 297 |
| 181 182 | 239 240 | 297 298 |
| 182 183 | 240 241 | 298 299 |
| 183 184 | 241 242 | 299 300 |
| 184 185 | 242 243 | 300 301 |
| 185 186 | 243 244 | 301 302 |
| 186 187 | 244 245 | 302 303 |

(continued)

| | | |
|---|---|---|
| 187 188 | 245 246 | 303 304 |
| 188 189 | 246 247 | 304 305 |
| 189 190 | 247 248 | 305 306 |
| 190 191 | 248 249 | 306 307 |
| 191 192 | 249 250 | 307 308 |
| 192 193 | 250 251 | 308 309 |
| 193 194 | 251 252 | 309 310 |
| 194 195 | 252 253 | 310 311 |
| 311 312 | 342 343 | 373 374 |
| 312 313 | 343 344 | 374 375 |
| 313 314 | 344 345 | 375 376 |
| 314 315 | 345 346 | 376 377 |
| 315 316 | 346 347 | 377 378 |
| 316 317 | 347 348 | 378 379 |
| 317 318 | 348 349 | 379 380 |
| 318 319 | 349 350 | 380 381 |
| 319 320 | 350 351 | 381 382 |
| 320 321 | 351 352 | 382 383 |
| 321 322 | 352 353 | 383 384 |
| 322 323 | 353 354 | 384 385 |
| 323 324 | 354 355 | 385 386 |
| 324 325 | 355 356 | 386 387 |
| 325 326 | 356 357 | 387 388 |
| 326 327 | 357 358 | 388 389 |
| 327 328 | 358 359 | 389 390 |
| 328 329 | 359 360 | 390 391 |
| 329 330 | 360 361 | 391 392 |
| 330 331 | 361 362 | 392 393 |
| 331 332 | 362 363 | 393 394 |
| 332 333 | 363 364 | 394 395 |
| 333 334 | 364 365 | 395 396 |
| 334 335 | 365 366 | 396 397 |
| 335 336 | 366 367 | 397 398 |
| 336 337 | 367 368 | 398 399 |
| 337 338 | 368 369 | 399 |
| 338 339 | 369 370 | |
| 339 340 | 370 371 | ©2004 Intel Corporation |
| 340 341 | 371 372 | |
| 341 342 | 372 373 | |

**Claims**

1. A wireless apparatus comprising:

   a forward error correction - FEC - coder to encode digital data using a low density parity check - LDPC - code, said FEC coder including:

      a computer readable storage medium (44) operative to store at least a first portion of a parity check matrix;
      a matrix multiplication unit (42) to multiply input data by a transpose of said first portion of a parity check matrix to generate modified data;
      a differential encoder (46) to differentially encode said modified data to generate coded data; and

a concatenation unit (48) to concatenate the input data and the coded data to

form a code word; the wireless apparatus further comprising:

a wireless transmitter to transmit a wireless signal that includes said code word; **characterised in that**:

said first portion of said parity check matrix is a sub-matrix consisting of the columns of said parity check matrix having a weight of 4 and the list file of Appendix A describes the data within said parity check matrix.

2.  The wireless apparatus of claim 1, wherein:

said wireless signal is an orthogonal frequency division multiplexing - OFDM - signal.

3.  The wireless apparatus of claim 1, further comprising:

a mapper, between said FEC coder and said wireless transmitter, to map said code word based on a predetermined modulation scheme; and
an inverse discrete Fourier transform unit to convert mapped data from a frequency domain representation to a time domain representation.

4.  The wireless apparatus of claim 1, wherein:

said first portion of said parity check matrix includes said entire parity check matrix.

5.  The wireless apparatus of claim 1, wherein:

said LDPC code is a (2000, 1600) bit-length code.

6.  A method comprising:

accessing a storage medium storing at least a first portion of a parity check matrix;
matrix multiplying input data by a transpose of the first portion of the parity check matrix (62);
processing a result of said matrix multiplication using differential encoding to generate coded data (64);
concatenating said input data and said coded data to form a code word (66); and
generating and transmitting a wireless signal that includes said code word (68);

**characterised in that**:

said first portion of said parity check matrix is a sub-matrix consisting of the columns of said parity check matrix having a weight of 4 and the list file of Appendix A describes the data within said parity check matrix.

7.  The method of claim 6, wherein:

said wireless signal is an orthogonal frequency division multiplexing - OFDM - signal.

8.  The method of claim 6, wherein:

said first portion of said parity check matrix includes said entire parity check matrix.

9.  The method of claim 6, wherein:

said parity check matrix defines a (2000, 1600) bit-length LDPC code.

10. The method of claim 6, wherein:

generating and transmitting a wireless signal includes mapping said code word into modulation symbols and processing said modulation symbols using an inverse discrete Fourier transform.

**11.** A computer-readable storage medium having instructions stored thereon that, when executed by a computing platform, operate to perform the steps of the method of any one of claims 6 to 10.

**Patentansprüche**

**1.** Drahtlose Vorrichtung, die Folgendes umfasst:

einen Vorwärtsfehlerkorrekturcodierer, FEC-Codierer, um digitale Daten unter Verwendung eines Codes mit einer Paritätsprüfung geringer Dichte, LDCP-Code, zu codieren, wobei der FEC-Codierer Folgendes enthält:

ein computerlesbares Speichermedium (44), das betreibbar ist, zumindest einen ersten Abschnitt einer Paritätsprüfungsmatrix zu speichern;
eine Matrixmultiplikationseinheit (42), um Eingangsdaten mit einer Transponierten des ersten Abschnitts einer Paritätsprüfungsmatrix zu multiplizieren, um modifizierte Daten zu erzeugen;
einen Differenzialcodierer (46), um die modifizierten Daten differenziell zu codieren, um codierte Daten zu erzeugen; und
eine Verkettungseinheit (48), um die Eingangsdaten und die codierten Daten zu verketten, um ein Codewort zu bilden; wobei die drahtlose Vorrichtung ferner Folgendes umfasst:

einen drahtlosen Sender, um ein drahtloses Signal, das das Codewort enthält, zu senden; **dadurch gekennzeichnet, dass**:

der erste Abschnitt der Paritätsprüfungsmatrix eine Untermatrix ist, die aus den Spalten der Paritätsprüfungsmatrix mit einem Gewicht von 4 besteht, und die Listendatei des Anhangs A die Daten innerhalb der Paritätsprüfungsmatrix beschreibt.

**2.** Drahtlose Vorrichtung nach Anspruch 1, wobei:

das drahtlose Signal ein Orthogonalfrequenzmultiplexsignal, OFDM-Signal, ist.

**3.** Drahtlose Vorrichtung nach Anspruch 1, die ferner Folgendes umfasst:

einen Abbilder zwischen dem FEC-Codierer und dem drahtlosen Sender, um das Codewort anhand eines vorgegebenen Modulationsschemas abzubilden; und
eine Einheit für die inverse diskrete FourierTransformation, um abgebildete Daten von einer Frequenzbereichsdarstellung in eine Zeitbereichsdarstellung umzusetzen.

**4.** Drahtlose Vorrichtung nach Anspruch 1, wobei:

der erste Abschnitt der Paritätsprüfungsmatrix die gesamte Paritätsprüfungsmatrix enthält.

**5.** Drahtlose Vorrichtung nach Anspruch 1, wobei:

der LDCP-Code ein Code einer (2000, 1600)-Bitlänge ist.

**6.** Verfahren, das Folgendes umfasst:

Zugreifen auf ein Speichermedium, das zumindest einen ersten Abschnitt einer Paritätsprüfungsmatrix speichert;
Matrixmultiplizieren der Eingangsdaten mit einer Transponierten des ersten Abschnitts der Paritätsprüfungsmatrix (62);
Verarbeiten eines Ergebnisses der Matrixmultiplikation unter Verwendung einer differenziellen Codierung, um codierte Daten (64) zu erzeugen;
Verketten der Eingangsdaten und der codierten Daten, um ein Codewort (66) zu bilden; und
Erzeugen und Senden eines drahtlosen Signals, das das Codewort (68) enthält;

**dadurch gekennzeichnet, dass**:

der erste Abschnitt der Paritätsprüfungsmatrix eine Untermatrix ist, die aus den Spalten der Paritätsprüfungsmatrix mit einem Gewicht von 4 besteht, und die Listendatei des Anhangs A die Daten innerhalb der Paritätsprüfungsmatrix beschreibt.

**7.** Verfahren nach Anspruch 6, wobei:

das drahtlose Signal ein Orthogonalfrequenzmultiplexsignal, OFDM-Signal, ist.

**8.** Verfahren nach Anspruch 6, wobei:

der erste Abschnitt der Paritätsprüfungsmatrix die gesamte Paritätsprüfungsmatrix enthält.

**9.** Verfahren nach Anspruch 6, wobei:

die Paritätsprüfungsmatrix einen LDCP-Code einer (2000, 1600)-Bitlänge definiert.

**10.** Verfahren nach Anspruch 6, wobei:

das Erzeugen und Senden eines drahtlosen Signals enthält, das Codewort in Modulationssymbole abzubilden und die Modulationssymbole unter Verwendung einer inversen diskreten Fourier-Transformierten zu verarbeiten.

**11.** Computerlesbares Speichermedium mit auf ihm gespeicherten Anweisungen, die dann, wenn sie durch eine Rechenplattform ausgeführt werden, arbeiten, um die Schritte des Verfahrens nach einem der Ansprüche 6 bis 10 auszuführen.


**Revendications**

**1.** Appareil sans fil comprenant :

un codeur de correction d'erreurs sans voie de retour - FEC - pour coder des données numériques au moyen d'un code de vérification de parité de faible densité - LDPC -, ledit codeur FEC comportant :

un support de mémorisation lisible par ordinateur (44) servant à mémoriser au moins une première partie d'une matrice de vérification de parité ;
une unité de multiplication matricielle (42) pour multiplier des données d'entrée par une transposée de ladite première partie d'une matrice de vérification de parité pour générer des données modifiées ;
un codeur différentiel (46) pour coder différentiellement lesdites données modifiées pour générer des données codées ; et
une unité de concaténation (48) pour concaténer les données d'entrée et les données codées pour former un mot de code ;

l'appareil sans fil comprenant en outre :

un émetteur sans fil pour émettre un signal sans fil qui comporte ledit mot de code ; **caractérisé en ce que** :

ladite première partie de ladite matrice de vérification de parité est une sous-matrice consistant en les colonnes de ladite matrice de vérification de parité d'un poids de 4 et le fichier de liste de l'annexe A décrit les données dans ladite matrice de vérification de parité.

**2.** Appareil sans fil selon la revendication 1, dans lequel :

ledit signal sans fil est un signal à multiplexage par répartition orthogonale de la fréquence, OFDM.

**3.** Appareil sans fil selon la revendication 1, comprenant en outre :

un dispositif de mise en correspondance, entre ledit codeur FEC et ledit émetteur sans fil, pour mettre en correspondance ledit mot de code en fonction d'un mécanisme de modulation prédéterminé ; et
une unité de transformée de Fourier discrète inverse pour convertir les données mises en correspondance d'une représentation dans le domaine fréquentiel en une représentation dans le domaine temporel.

4.  Appareil sans fil selon la revendication 1, dans lequel :

ladite première partie de ladite matrice de vérification de parité comporte toute ladite matrice de vérification de parité.

5.  Appareil sans fil selon la revendication 1, dans lequel :

ledit code LDPC est un code d'une longueur binaire de (2000, 1600).

6.  Procédé comprenant :

la sollicitation d'un support de mémorisation mémorisant au moins un première partie d'une matrice de vérification de parité ;
la multiplication matricielle de données d'entrée par une transposée de la première partie de la matrice de vérification de parité (62) ;
le traitement d'un résultat de ladite multiplication matricielle au moyen d'un codage différentiel pour générer des données codées (64) ;
la concaténations desdites données d'entrée et desdites données codées pour former un mot de code (66) ; et
la génération et l'émission d'un signal sans fil qui comporte ledit mot de code (68) ;

**caractérisé en ce que** :

ladite première partie de ladite matrice de vérification de parité est une sous-matrice consistant en les colonnes de ladite matrice de vérification de parité ayant un poids de 4 et le fichier de liste de l'annexe A décrit les données dans ladite matrice de vérification de parité.

7.  Procédé selon la revendication 6, dans lequel :

ledit signal sans fil est un signal à multiplexage par répartition orthogonale de la fréquence, OFDM.

8.  Procédé selon la revendication 6, dans lequel :

ladite première partie de ladite matrice de vérification de parité comporte toute ladite matrice de vérification de parité.

9.  Procédé selon la revendication 6, dans lequel :

ladite matrice de vérification de parité définit un code LDPC d'une longueur binaire de (2000, 1600).

10. Procédé selon la revendication 6, dans lequel :

la génération et l'émission d'un signal sans fil comporte la mise en correspondance dudit mot de code avec des symboles de modulation et le traitement desdits symboles de modulation en utilisant une transformée de Fourier discrète inverse.

11. Support de mémorisation lisible par ordinateur sur lequel sont mémorisées des instructions qui, à leur exécution par une plate-forme informatique, servent à exécuter les étapes du procédé selon l'une quelconque des revendications 6 à 10.

10

18

AP

USER DEVICE

12

USER DEVICE

14

USER DEVICE

16

Fig. 1

20

$\bar{u}$ → | FEC (22) | → | MAPPER (24) | → | SERIAL TO PARALLEL (26) | → | IFFT (28) | → | GI ADDITION (30) | → | WIRELESS TX (32) | → 34

**Fig. 2**

EP 1 712 027 B1

Fig. 3

Fig. 4

60

62

| MATRIX MULTIPLY INPUT DATA BY A TRANSPOSE OF A FIRST PORTION OF A PARITY CHECK MATRIX |

64

| PROCESS A RESULT OF THE MATRIX MULTIPLICATION USING A DIFFERENTIAL ENCODER TO GENERATE CODED DATA |

66

| CONCATENATE THE INPUT DATA AND THE CODED DATA TO FORM A CODE WORD |

68

| GENERATE AND TRANSMIT A WIRELESS SIGNAL THAT INCLUDES THE CODE WORD |

**Fig. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YANG M et al.** Design of Efficiently Encodable Moderate-Length High-Rate Irregular LDPC Codes. *Proceedings of the Annual Conference on Communication, Control and Computing,* 02 October 2002, 1415-1424

- Performance of low-density parity-check (LDPC) coded OFDM systems. **FUTAKI H et al.** ICC 2002 proceedings NY, April 28 - May 2, 2002. IEEE, 28 April 2002, vol. 1, 1696-1700
- LDPC-based space-time coded OFDM systems performances over correlated fading channels. **SYED M J et al.** APCC 2003. IEEE, 21 September 2003, vol. 2, 590-594